# FASCICULE DE BREVET EUROPEEN

(11) **EP 0 819 279 B1**
(45) Date de publication et mention de la délivrance du brevet: **23.12.1998**
(21) Numéro de dépôt: 96911001.4
(22) Date de dépôt: 29.03.1996
(51) Int. Cl.: G06F 17/50, G06F 17/00

(54) **PROCEDE DE SAISIE GRAPHIQUE D'APPLICATION DE TRAITEMENT DE SIGNAL**
VERFAHREN ZUR GRAPHISCHEN ERFASSUNG EINER SIGNALVERARBEITUNGSANWENDUNG
SIGNAL PROCESSING APPLICATION GRAPHIC ACQUISITION METHOD

(30) Priorité: 07.04.1995 FR 9504175
(43) Date de publication de la demande: 21.01.1998
(73) Titulaire: THOMSON-CSF, 75008 Paris (FR); FRANCE TELECOM, 75015 Paris (FR)
(72) Inventeur: DEMEURE, Alain-Thomson-CSF SCPI, F-92402 Courbevoie Cédex (FR); LAFAGE, Anne-Thomson-CSF SCPI, F-92402 Courbevoie Cédex (FR)
(74) Mandataire: Chaverneff, Vladimir
(86) Numéro de dépôt international: FR9600479
(87) Numéro de publication internationale: WO9631830

(56) Documents cités:
- WO-A-91/06060
- IEEE INTERNATIONAL CONFERENCE ON ACOUSTICS SPEECH AND SIGNAL PROCESSING, 3 - 6 Avril 1990, ALBUQUERQUE US, pages 1057-1060, XP000146955 GENIN ET AL: "dsp specification using the silage language"
- IEEE INTERNATIONAL CONFERENCE ON COMPUTER-AIDED DESIGN, 11 - 14 Novembre 1991, SANTA CLARA US, pages 272-275, XP000315186 VANHOOF ET AL: "compiling multi-dimensional data streams into distributed dsp asic memory"

## Description

La présente invention se rapporte à un procédé de saisie graphique d'application de traitement de signal, et en particulier à un procédé de spécification de caractéristiques de circuits de traitement de signal qui fait appel à une entrée graphique.

Dans le cas particulier de la conception des circuits intégrés de traitement de signal, il existe des outils logiciels exploités sur stations de travail permettant de définir les blocs constitutifs d'une chaîne et de spécifier graphiquement leurs interconnexions. Ces outils sont appropriés à une description de traitement sous l'aspect de flots de données circulant entre les blocs. Dans le cas des chaînes de traitement de signal, comme celles mises en oeuvre dans les systèmes de détection multicapteurs, l'aspect flot de données est inapproprié, car le signal a une structure multidimensionnelle. C'est le cas par exemple si L capteurs fournissent d'abord les L lignes d'une matrice dont les C colonnes alimentent ensuite C calculs. Seule la structuration des données en tableaux permet de spécifier sans ambiguïté cette organisation des calculs.

On connaît d'après les documents WOA 9106060 (VLSI TECHNOLOGY), IEEE INTERNATIONAL CONFERENCE ON ACOUSTICS SPEECH AND SIGNAL PROCESSING, 3 - 6 Avril 1990, ALBUQUERQUE US, pages 1057-1060, XP000146955 GENIN ET AL. « dsp specification using the silage language» et IEEE INTERNATIONAL CONFERENCE ON COMPUTER-AIDED DESIGN, 11-14 Novembre 1991, SANTA CLARA US, pages 272-275, XXP000315185 VANHOOF ET AL : « compiling multi-dimensional data streams into distributed dsp asic memory » des procédés permettant de réaliser des circuits de traitement de signal, de façon relativement complexe.

La présente invention a pour objet un procédé permettant de spécifier des chaînes de traitement de signal notamment dans le but de concevoir des circuits de traitement de signal, mais aussi dans le but de produire du logiciel pour des machines de traitement de signal existantes, et cela quelle que soit la structure du signal, mono ou multidimensionnelle.

L'objet de l'invention est un procédé permettant à un utilisateur de spécifier des chaînes de traitement de signal numérique au moyen d'une entrée graphique et d'un calculateur numérique auquel est associée une bibliothèque comportant un jeu de transformations élémentaires utilisées en traitement de signal, caractérisé en ce que l'utilisateur structure les données à traiter en au moins un tableau visualisé sous forme de repères cartésiens, les dimensions de chaque tableau correspondant à des grandeurs physiques, que pour chaque transformation il établit graphiquement un tableau d'application opérande et un tableau d'application résultat, et choisit dans la bibliothèque une transformation élémentaire avec ses motifs d'entrée et de sortie, ces motifs correspondant au nombre d'échantillons définissant la fonction élémentaire, qu'il met en correspondance, pour chaque axe de coordonnées cartésiennes, au moins deux éléments du motif opérande et du tableau d'application opérande d'une part, du motif résultat et du tableau d'application résultat d'autre part, et que le calculateur utilise les relations affines caractéristiques des accès dans les tableaux en traitement de signal pour exécuter complètement la transformation en itérant la transformation élémentaire autant de fois que nécessaire pour que le tableau résultat soit entièrement rempli par des ensembles de points identiques à l'ensemble de points correspondants au motif de sortie.

Ceci est possible grâce au fait que les relations définissant les mises en correspondance des tableaux et des motifs et les itérations pour le remplissage des tableaux sont linéaires. Ces mises en correspondance équivalent à des relations affines. Ainsi, grâce à l'invention, il est possible par une suite d'opérations très simples, de spécifier des chaînes de traitement numérique de signal très complexes.

La présente invention sera mieux comprise à la lecture de la description détaillée d'un mode de réalisation pris à titre d'exemple non limitatif et illustré par le dessin annexé, sur lequel :
- la figure 1 est un schéma illustrant le principe de représentation graphique d'un tableau,
- la figure 2 est un schéma illustrant le principe de représentation graphique d'un tableau à trois dimensions, conformément à l'invention,
- les figures 3 à 5 sont des schémas illustrant respectivement, conformément à l'invention, le principe de la saisie d'une transformation, le principe de l'accès ajustage et le principe de l'accès pavage, et
- les figures 6 à 8 sont des vues de l'écran du terminal de saisie graphique lorsque, conformément à l'invention, l'utilisateur, respectivement, crée un tableau, procède à l'accès ajustage, et procède à l'accès pavage.

Une application de traitement de signal opère en général sur des flots d'échantillons foumis par des codeurs transformant des grandeurs analogiques en grandeurs numériques. C'est le cas notamment dans les radars et dans les sonars.

Pour pouvoir mettre en oeuvre l'invention, on structure les données à traiter en tableaux à une ou plusieurs dimensions, ces dimensions pouvant être finies ou infinies. Les dimensions de ces tableaux correspondent à des grandeurs physiques, en particulier spatiales, temporelles ou fréquentielles. Dans le cas d'une dimension temporelle, la taille peut être infinie.

Une application est constituée d'une suite de transformations. La transformation de tête opère sur un tableau rempli par les échantillons fournis par les codeurs. De proche en proche, le tableau résultat d'une transformation est utilisé comme tableau opérande de la (ou des) transformation (s) suivante (s).

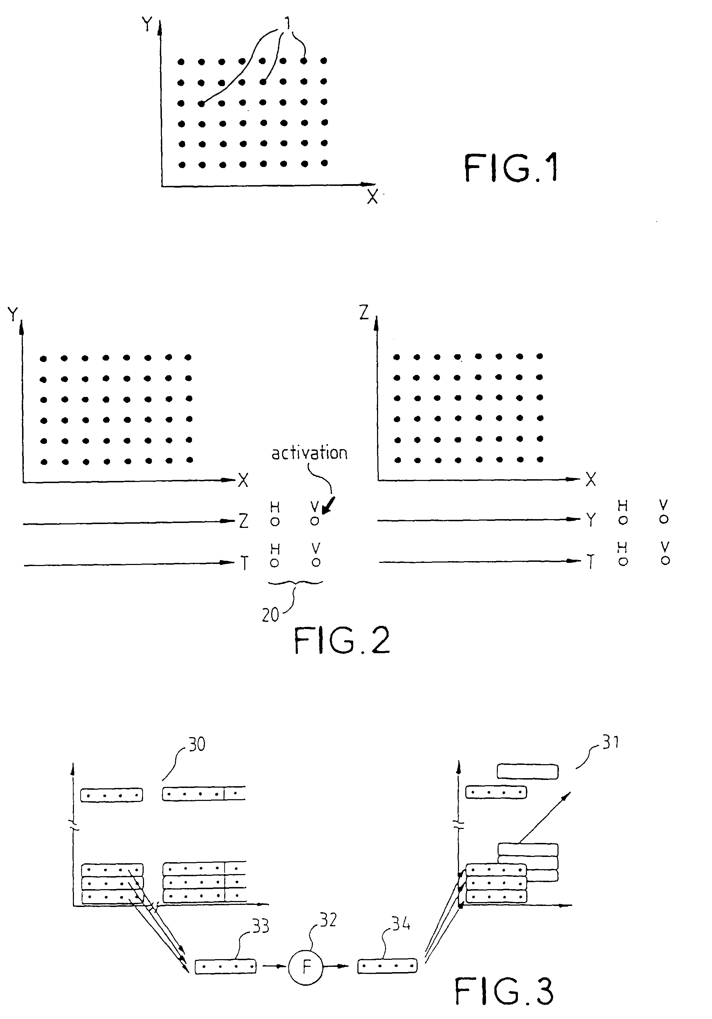

On a représenté en figure 1 le principe de représentation graphique d'un tableau. Cette représentation reprend la vue géométrique classique d'un repère cartésien où ne figurent que les points 1 de coordonnées entières. Les axes du repère figurent les dimensions (paramètres tels que temps, fréquence, nombre de sources, ...), et l'outil graphique permet de leur attribuer un nom, X ou Y par exemple, et une taille. Dans le cas où le nombre de dimensions est supérieur à 2, on adjoint des axes supplémentaires en parallèle sous l'axe horizontal. A chaque axe supplémentaire sont associés deux "boutons" 20 (en termes d'éditeur graphique) permettant son échange avec l'axe horizontal (H) ou vertical (V) du repère cartésien. Cette possibilité est illustrée sur la figure 2.

On a représenté sur la figure 3 le principe de saisie d'une seule transformation (la spécification d'une application nécessite en règle générale la saisie de plusieurs transformations). On trouve sur cette figure, un tableau application opérande 30, un tableau d'application résultat 31, ainsi qu'une application élémentaire 32 avec ses motifs d'entrée 33 et ses motifs de sortie 34. L'application élémentaire met en oeuvre une transformation élémentaire symbolisée par F, par exemple une FFT, opérant sur une suite d'échantillons temporels pour élaborer une suite de raies fréquentielles. Cette représentation suppose qu'au moins le motif résultat soit structuré en tableau et que pour exécuter complètement la transformation on itère la transformation élémentaire autant de fois que nécessaire pour que le tableau résultat soit entièrement rempli par des ensembles de points identiques à l'ensemble de points correspondant au motif de sortie. Tout se passe comme si, à chaque itération de la transformation élémentaire, on ajoutait un "pavé" contribuant à la construction du tableau résultat. Un pavé est équivalent à l'ensemble des points correspondant à un motif placé (au sens anglo-saxon de "mapped") sur un tableau. La position où l'on place le pavé résultat définit la position du pavé opérande correspondant.

Les accès dans les tableaux sont régis en traitement de signal par des relations affines, ce qui permet de limiter à l'extrême le nombre d'informations qu'il faut rajouter à la figure 3 pour spécifier complètement l'exécution d'une transformation, et cela graphiquement.

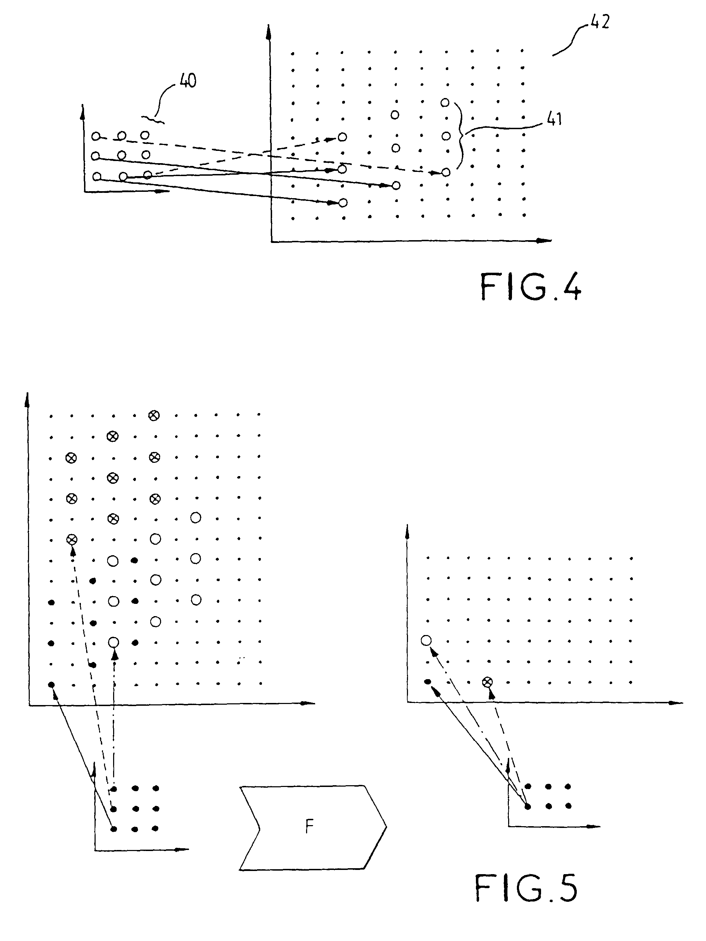

Pour exposer clairement le principe de cette spécification, on distinguera deux types d'accès, étant entendu que cette distinction n'est pas caractéristique de l'invention en tant que telle. Un premier type d'accès va spécifier comment un pavé s'oriente dans le tableau sur lequel il est appliqué et, le cas échéant, le sous-échantillonne. La figure 4 illustre la mise en correspondance des composantes du motif 40 avec les composantes du tableau 42, constituant le pavé 41. Deux points suffisent pour chaque dimension, les traits en pointillé indiquant l'extrapolation. Pour chaque dimension, à partir de ces deux points, un logiciel intégré à l'outil graphique calcule la relation linéaire permettant de passer des coordonnées des composantes du motif à celles du tableau. Une composante est avantageusement commune à toutes les dimensions et permet l'économie d'un point par dimension. On appelle ajustage la spécification de ce premier type d'accès.

II reste à définir comment la position d'un pavé résultat commande la position des pavés opérandes, et/ou des autres pavés résultats s'il existe des tableaux de résultats multiples. On remarquera que l'ajustage ayant été spécifié, les positions de toutes les composantes d'un pavé se déduisent de la position d'une seule composante. II suffit donc de définir comment la position d'une seule composante du pavé résultat contrôle la position d'une seule composante de tout autre pavé.

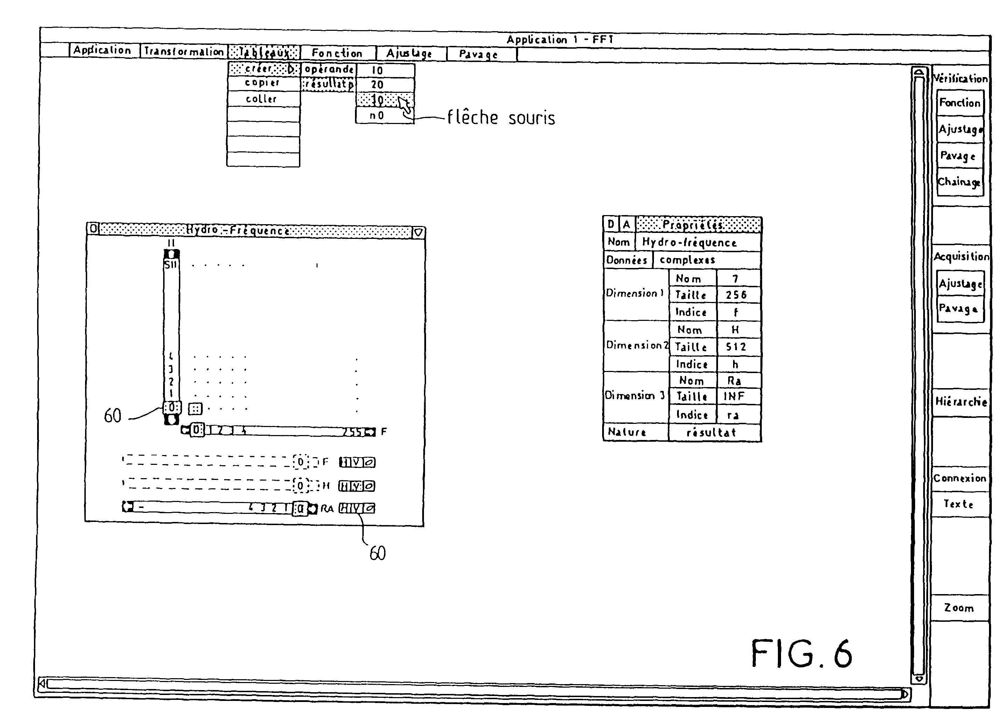

Comme pour l'ajustage, la spécification des accès de deuxième type se fait par mise en correspondance des positions du motif opérande à raison de deux positions par dimension du tableau résultat: ceci est illustré par la figure 5. Une position est complètement décrite par la position d'une seule composante du motif. On appelle pavage la spécification de ce deuxième type d'accès.

On a représenté en figures 6 à 8 des exemples de vues à l'écran produites par l'outil graphique de l'invention.

La figure 6 représente une vue de l'écran de saisie lors de la création d'un tableau opérande relatif à une application de traitement de signal.

Dans le menu déroulant, en haut de l'écran, on vient cliquer avec la souris sur "tableaux" puis sur "créer", "opérande" et "3D". A l'écran apparaît d'une part une fenêtre intitulée, dans le cas présent, "Hydro-Fréquence" (pour "n° d' hydrophone" et "Fréquence") et, d'autre part, une autre fenêtre intitulée "propriétés" que l'on renseigne à partir du clavier. La fenêtre "Hydro-Fréquence" est occupée, dans sa partie supérieure, par les deux axes de coordonnées H (n° d'hydrophone-en ordonnées) et F. (fréquence). Dans la partie inférieure de cette fenêtre se trouvent les emplacements pour le "rangement" des trois axes de coordonnées que l'on a prévu d'utiliser (F, H et RA, ce demier correspondant à récurrence). Dans l'exemple de la figure 6, les axes F et H étant utilisés, leurs emplacements de la partie inférieure de la fenêtre sont représentés en traits interrompus. Seul l'axe RA, mis en réserve, est représenté en trait continu. Pour remplacer un axe par un autre, en vue de déterminer une autre transformation, par exemple pour remplacer l'axe H par l'axe RA, il suffit de cliquer sur le bouton 60 situé à droite de l'axe RA et marqué V comme "vertical" ; la permutation se fait alors instantanément. Chaque axe est muni d'une curseur 60 permettant de positionner un point courant dans le tableau, en cliquant sur les coordonnées désirées.

La seconde fenêtre se présente sous forme d'un tableau simplifié comportant les données essentielles relatives aux axes de coordonnées disponibles, à savoir, pour chacun d'eux, son nom, sa taille (nombre d'éléments pour une période finie, ou bien taille infinie), et indice (c'est-à-dire F, H, RA... comme indiqué précédemment), ainsi que la nature du tableau créé (opérande ou résultat).

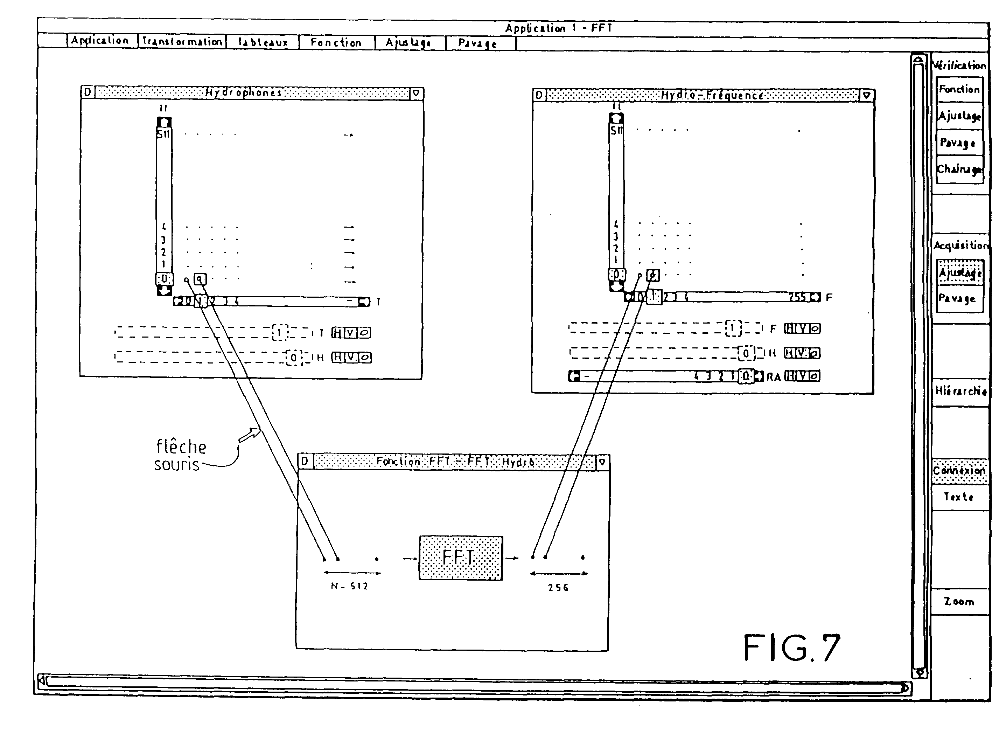

Après des actions non décrites de spécifications complémentaires, la figure 7 représente une vue de l'écran de saisie lors de l'accès appelé ajustage. Sur cette figure 7, on a représenté une fenêtre "HydroFréquence", une fenêtre "Hydrophone", (qui représente un tableau résultat, obtenu de la même façon que le tableau opérande de la figure 6), dans laquelle sont figurés les axes H et T (temps, de taille infinie) et une fenêtre "Fonction FFT-FFT Hydro", qui représente une fonction élémentaire de FFT avec le nombre de points d'entrée et le nombre de points de sortie (ici, respectivement 512 et 256). A l'aide de la souris, on clique sur les fonctions "ajustage" et "connexion" pour les activer. Pour une transformation donnée, ici une FFT, à l'aide de la souris par un clic maintenu, on joint les points entre d'une part le motif opérande (512 points de FFT) et le tableau opérande et d'autre part entre le motif résultat (256 points de FFT) et le tableau résultat ("Hydro-Fréquence").

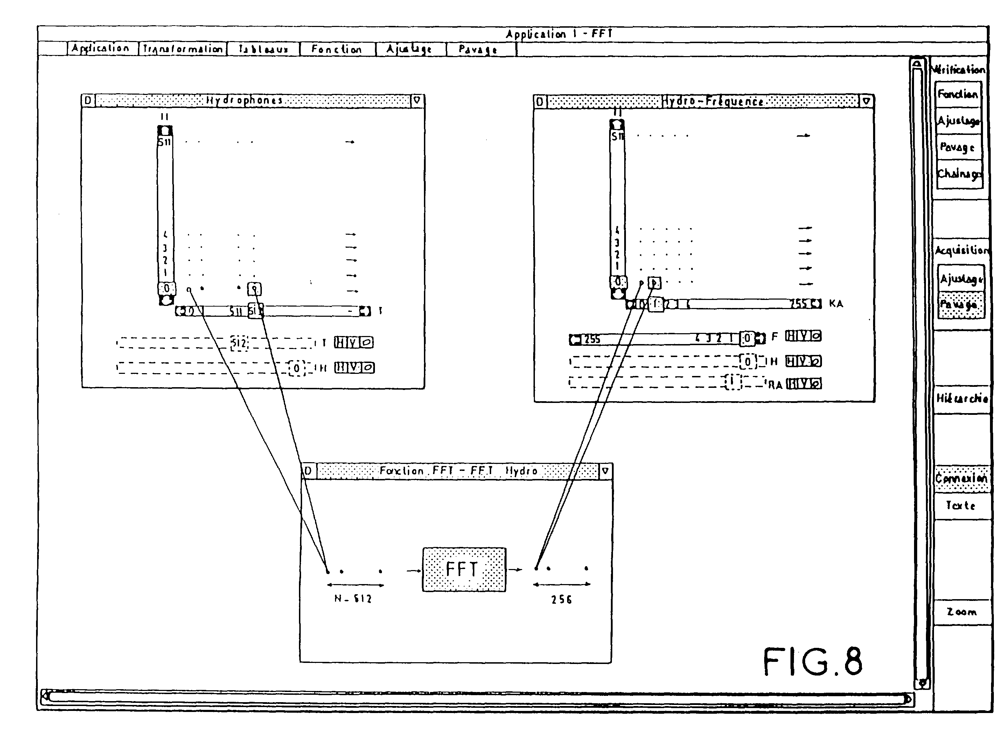

Enfin la figure 8 représente une vue de l'écran de saisie lors de l'accès appelé pavage par une dimension résultat. Cette figure 8 comporte les mêmes fenêtres que la figure 7 l'axe RA remplaçant l'axe F dans la fenêtre "Hydro-Fréquence". A l'aide de la souris, on clique sur les fonctions "Pavage" et "Connexion" pour les activer. Comme précédemment, à l'aide de la souris, on joint un point de motif opérande à un point du tableau opérande, puis on fait la même chose côté résultat.

Lorsque l'application complète a été spécifiée avec le procédé qui vient d'être décrit, on transforme les informations acquises au cours de la saisie en codes pour calculateurs numériques. Cette génération de codes se fait de façon classique, et ne sera donc pas décrite ici.

## Revendications

1. Procédé permettant à un utilisateur de spécifier des chaînes de traitement de signal numérique au moyen d'une entrée graphique et d'un calculateur numérique auquel est associée une bibliothèque comportant un jeu de transformations élémentaires utilisées en traitement de signal, caractérisé en ce que l'utilisateur structure les données à traiter en au moins un tableau visualisé sous forme de repères cartésiens (X, Y, Z, T), les dimensions de chaque tableau correspondant à des grandeurs physiques, que pour chaque transformation il établit graphiquement un tableau d'application opérande (30) et un tableau d'application résultat (31), et choisit dans la bibliothèque une transformation élémentaire (32) avec ses motifs d'entrée (33) et de sortie (34), ces motifs correspondant au nombre d'échantillons définissant la fonction élèmentaire, qu'il met en correspondance, pour chaque axe de coordonnées cartésiennes, au moins deux éléments du motif opérande et du tableau d'application opérande d'une part, du motif résultat et du tableau d'application résultat d'autre part, et que le calculateur utilise les relations affines caractéristiques des accès dans les tableaux en traitement de signal pour exécuter complètement la transformation en itérant la transformation élémentaire autant de fois que nécessaire pour que le tableau résultat soit entièrement rempli par des ensembles de points identiques à l'ensemble de points correspondants au motif de sortie.

2. Procédé selon la revendication 1, pour une chaîne de traitement de signal, caractérisé en ce que l'utilisateur réalise plusieurs transformations consécutives, en utilisant le tableau résultat d'une transformation comme tableau opérande de la (des) transformation (s) suivante (s).

3. Procédé selon la revendication 1 ou 2, caractérisé en ce que lorsqu'un traitement implique plus de deux dimensions, les dimensions non utilisées dans les tableaux visualisés sur l'écran de l'outil graphique sont visualisées à côté de ces tableaux et activables à l'aide de "boutons" (20, 60)

4. Procédé selon l'une des revendications précédentes, caractérisé en ce que lorsque toutes les transformations relatives à une application ont été déterminées, le calculateur transforme les informations acquises au cours de la saisie en codes numériques.

## Patentansprüche

1. Verfahren, mit dem ein Benutzer digitale Signalverarbeitungsketten mithilfe eines graphischen Eingangs und eines digitalen Rechners spezifizieren kann, an den eine Bibliothek angeschlossen ist, die einen Satz von bei der Signalverarbeitung verwendeten Elementartransformationen enthält, dadurch gekennzeichnet, daß der Benutzer die zu verarbeitenden Daten in mindestens eine Tabelle strukturiert, die in Form eines kartesischen Koordinatensystems (X, Y, Z, T) angezeigt wird, wobei die Dimensionen jeder Tabelle physikalischen Größen entsprechen, daß der Benutzer für jede Transformation graphisch eine Operanden-Anwendungstabelle (30) und eine Ergebnis-Anwendungstabelle (31) erstellt und aus der Bibliothek eine elementare Transformation (32) mit ihren Eingangsmotiven (33) und Ausgangsmotiven (34) wählt, wobei diese Motive der Anzahl von Signaltastproben zur Definition der Elementarfunktionen entsprechen, daß der Benutzer für jede kartesische Koordinatenachse mindestens zwei Elemente des Operandenmotivs und der Operanden-Anwendungstabelle einerseits und des Ergebnismotivs sowie der Ergebnis-Anwendungstabelle andrerseits in Korrespondenz bringt, und daß der Rechner die für die Zugänge in den Signal-Verarbeitungstabellen charakteristischen affinen Beziehungen verwendet, um die Transformation vollständig durchzuführen, indem er die elementare Transformation so oft wiederholt, wie dies notwendig ist, damit die Ergebnistabelle vollständig durch Gruppen von Punkten gefüllt wird, die der Gruppe von entsprechenden Punkten des Ausgangsmotivs gleichen.

2. Verfahren nach Anspruch 1 für eine Signal-Verarbeitungskette, dadurch gekennzeichnet, daß der Benutzer nacheinander mehrere Transformationen durchführt, indem er die Ergebnistabelle einer Transformation als Operandentabelle der nächsten Transformation(-en) verwendet.

3. Verfahren nach Anspruch 1 oder 2, dadurch gekennzeichnet, daß, wenn die Verarbeitung mehr als zwei Dimensionen erfordert, die in den auf dem Bildschirm des graphischen Hilfsmittels sichtbar gemachten Tabellen nicht verwendeten Dimensionen neben diesen Tabellen angezeigt werden und mithilfe von "Tasten" (20, 60) aktiviert werden können.

4. Verfahren nach einem der vorstehenden Ansprüche, dadurch gekennzeichnet, daß nach der Bestimmung aller Transformationen bezüglich einer Anwendung der Rechner die während der Erfassung ermittelten Informationen in digitale Kodes umwandelt.

## Claims

1. Method allowing a user to specify digital signal processing chains by means of a graphics input and a digital computer with which there is associated a library containing a set of elementary transformations used in signal processing, characterized in that the user structures the data to be processed into at least one table displayed in the form of cartesian grids (X, Y, Z, T), the dimensions of each table corresponding to physical quantities, in that for each transformation he graphically compiles an operand application table (30) and a result application table (31), and chooses from the library an elementary transformation (32) together with its input array (33) and output array (34), these arrays corresponding to the number of samples defining the elementary function, in that he matches, for each cartesian coordinate axis, at least two elements of the operand array and of the operand application table on the one hand, of the result array and of the result application table on the other hand, and in that the computer uses the affine relations characteristic of the accesses to the tables for signal processing in order completely to execute the transformation by iterating the elementary transformation as many times as necessary for the result table to be entirely filled with collections of points identical to the collection of points corresponding to the output array.

2. Method according to Claim 1, for a signal processing chain, characterized in that the user carries out several consecutive transformations by using the result table from one transformation as operand table for the following transformation(s).

3. Method according to Claim 1 or 2, characterized in that when a processing operation involves more than two dimensions, the unused dimensions in the tables displayed on the screen of the graphics tool are displayed alongside these tables and can be activated with the aid of "buttons" (20, 60).

4. Method according to one of the preceding claims, characterized in that when all the transformations relating to an application have been determined, the computer transforms the information captured in the course of entry into digital codes.
